(19)

Europäisches
Patentamt
European
Patent Office
Office européen
des brevets

(11) **EP 2 996 246 B1**

(12) **EUROPEAN PATENT SPECIFICATION**

(45) Date of publication and mention
of the grant of the patent:
**22.04.2020  Bulletin 2020/17**

(51) Int Cl.:
***H03K 3/013*** (2006.01)

(21) Application number: **15183918.0**

(22) Date of filing: **04.09.2015**

(54) **METHODS AND STRUCTURES TO GENERATE ON/OFF KEYED CARRIER SIGNALS FOR SIGNAL ISOLATORS**

VERFAHREN UND STRUKTUREN ZUR ERZEUGUNG CODIERTER EIN-/AUS-TRÄGERSIGNALE FÜR SIGNALISOLATOREN

PROCÉDÉS ET STRUCTURES PERMETTANT DE GÉNÉRER DES SIGNAUX DE PORTEUSE MARCHE/ARRÊT VERROUILLÉS POUR DES ISOLATEURS DE SIGNAUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.09.2014   US 201414486937**
**15.09.2014   US 201414486951**

(43) Date of publication of application:
**16.03.2016   Bulletin 2016/11**

(60) Divisional application:
**20160893.2**

(73) Proprietor: **Analog Devices Global Unlimited Company**
**Hamilton (BM)**

(72) Inventors:
• YUN, Ruida
  **Weston, MA 02493 (US)**
• SUN, Yuanjie
  **Haidian District Beijing (CN)**
• CHEN, Baoxing
  **Westford, MA 01886 (US)**

(74) Representative: **Horler, Philip John**
**Withers & Rogers LLP**
**4 More London Riverside**
**London SE1 2AU (GB)**

(56) References cited:
**WO-A1-81/00658          WO-A1-2012/085951**
**JP-A- 2011 134 347     US-A1- 2009 168 462**
**US-A1- 2009 195 082**

## Description

### BACKGROUND

The present invention relates to signal isolators and, particularly, signal isolators that operate according to an on-off keyed signal protocol.

Isolators are devices that exchange data signals between two galvanically isolated circuit systems. The circuit systems each operate in different voltage domains, which may include different source potentials and different grounds. Isolation devices may provide data exchange across an isolation barrier, which maintains the galvanic isolation. Typical isolation devices include micro-transformers, capacitors, magneto-resistors/giant magneto-resistors and opto-electronic devices.

On-off keying ("OOK") is a signaling protocol that identifies a digital state based on the type of signal that is transmitted through the isolation barrier. A first digital data state (say, a digital "1") might be signaled by transmitting a periodic signal across the isolation barrier. A second digital data state (a digital "0") might be signaled by transmitting no signal across the isolation barrier. A receiver circuit would detect the presence or absence of the periodic signal and decode a digital output signal therefrom.

OOK-based signal isolators typically have inefficient designs. For example, isolator transmitters may include a high-frequency oscillator separate from the isolator device to generate a carrier that becomes the periodic signal. Moreover, transmitters often are power-hungry devices. Accordingly, the inventors perceive a need in the art for an improved transmitter architecture for OOK-based signal isolators.

WO 2012/085951 A1 describes a low voltage isolation switch, in particular for a transmission channel for ultra-sound applications. A low voltage isolation circuit is inserted between a connection node to a matrix of switches suitable for receiving a high voltage signal and a connection terminal to a load suitable for transmitting said high voltage signal to said load.

US 2009/0195082 A1 describes a solid state relay including an oscillator circuit responsive to a control signal for generating an a.c. signal; an isolation transformer having a primary winding which forms a part of the tank circuit of the oscillator circuit and a secondary winding; a rectifier responsive to the a.c. signal from the oscillator circuit for providing a d.c. drive signal; and a switch circuit responsive to the drive signal to open and close the relay.

### BRIEF DESCRIPTION OF THE DRAWINGS

FIG. 1 illustrates an isolator system according to an embodiment of the present invention.

FIG. 2 illustrates a transmitter and exemplary signals therefor according to an embodiment of the present invention.

FIG. 3 illustrates a transmitter and exemplary signals therefor according to another embodiment of the present invention.

FIG. 4 illustrates a transmitter and exemplary signals therefor according to a further embodiment of the present invention.

FIG. 5 illustrates a transmitter and exemplary signals therefor according to yet another embodiment of the present invention.

FIG. 6 illustrates a transmitter according to another embodiment of the present invention.

FIG. 7 illustrates a transmitter according to a further embodiment of the present invention.

FIG. 8 is a schematic diagram illustrating an isolator system according to another embodiment of the present invention.

FIG. 9 illustrates an isolator system according to an embodiment of the present invention.

FIG. 10 is a circuit diagram of a voltage regulator according to an embodiment of the present invention.

FIG. 11 illustrates a receiver according to an embodiment of the present invention.

FIG. 12 illustrates exemplary signals that may be processed by the receiver of FIG. 11.

FIG. 13 illustrates a current comparator according to an embodiment of the present invention.

FIG. 14 illustrates exemplary signals that may be processed by the comparator of FIG. 13.

FIG. 15 illustrates a receiver according to another embodiment of the present invention.

FIG. 16 illustrates output driver according to another embodiment of the present invention.

FIG. 17 illustrates a receiver according to another embodiment of the present invention.

### DETAILED DESCRIPTION

The invention is described by the content of the independent claims. The present invention provides an oscillator circuit coupled to an isolator device, a control switch, and a quenching switch. The control switch is coupled between the oscillator circuit and a voltage supply and is controlled by an input signal to be transmitted by the system. The control switch, therefore, may gate operation of the oscillator between an ON and an OFF state. The quenching switch is coupled between two components of the oscillator and becomes conductive during a transition from an ON state of the oscillator to an OFF state to short current with the oscillator. Other embodiments may include a current injection circuit, coupled to the oscillator, that becomes active during a transition from an OFF state of the oscillator to an ON state of the oscillator as determined by the input signal.

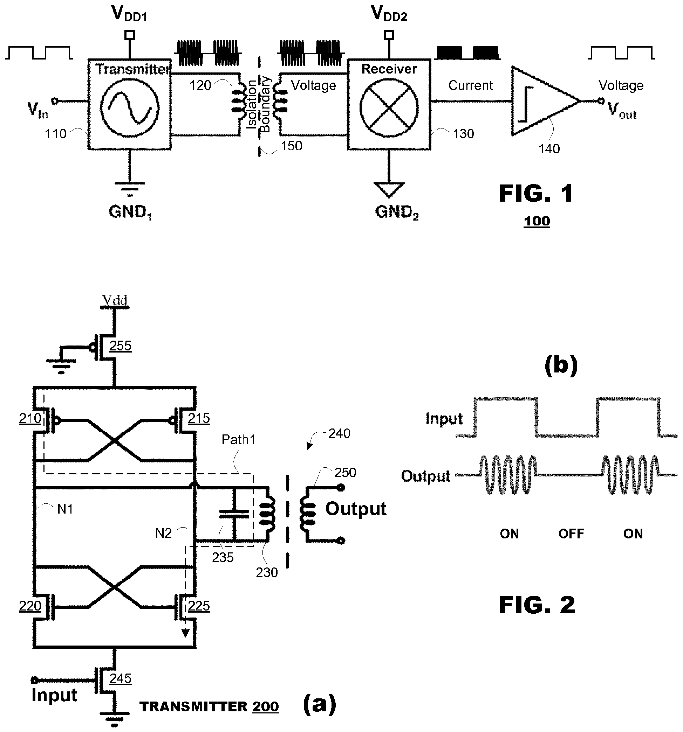

FIG. 1 illustrates an isolator system 100 according to an embodiment of the present invention. The system 100 may include a transmitter 110, an isolator 120, a receiver 130 and an output driver 140. The isolator 120 may span an isolation boundary 150, which galvanically isolates two voltage domains from each other. The transmitter 110 may belong to a first voltage domain, which possesses its own voltage and ground supplies (shown as $V_{DD1}$, $GND_1$), and the receiver 130 and output driver 140 may belong to a second voltage domain, which possesses separate voltage and ground supplies ($V_{DD2}$, $GND_2$) from the supplies of the first voltage domain. The isolation boundary 150 may prevent communication of voltages from one domain to the other.

The system 100 may be provided for communication of digital data from the first voltage domain to the second voltage domain by on-off keying ("OOK" for short). In such an embodiment, the transmitter 110 may receive an input signal that takes one of two binary voltage levels. The transmitter 110 may generate an output signal having a state that is determined from the state of the input signal. For example, if the input signal corresponds to a binary value of "1," the transmitter 110 may generate a periodic signal as its output but, if the input signal corresponds to a binary value of "0," the transmitter 110 may output an inert signal (no activity). This action of toggling between an active state and an inactive state based on the state of the input signal represents one example of an on-off keyed output.

The isolator 120 may be provided as a micro-transformer (shown in FIG 1), capacitive isolators and/or a magneto-resistive isolator. The isolator 120 may receive the output from the transmitter 110 in the first voltage domain and pass a received signal to the receiver 130 in the second voltage domain. Although the received signal is illustrated as a copy of the OOK output that the isolator 120 receives from the transmitter 110, the received signal may include perturbations (not illustrated) that are induced into the signal by the isolator 120, for example, shifts in voltage, distortions induced by the isolator's temporal response and noise effects. The received signal may be provided to the receiver 130 as a voltage.

The receiver 130 may generate an OOK current signal from the signal supplied to it by the isolator 120.

The output driver 140 may generate a binary voltage signal from the current signal supplied to it by the receiver 130. In an embodiment, the receiver 130 and output driver 140 may exchange current domain signals to provide a low latency output in response to OOK signals provided by the isolator 120.

FIG. 2 (a) illustrates a transmitter 200 according to an embodiment of the present invention. The transmitter 200 may include a first pair of cross-coupled transistors 210, 215, a second pair of cross-coupled transistors 220, 225, an inductor 230 and a capacitor 235. The inductor 230 may be provided as a first winding 230 of a transformer 240 that forms the isolator 120 (FIG. 1) of the system. The transmitter 200 also may include a fifth transistor 245 for an input signal INPUT.

Two transistors 210 and 220 may be connected together at a first node N1. The other two transistors 215, 225 may be connected together at a second node N2. Gates of the transistors 210, 220 may be connected to the second node N2 and gates of the transistors 215, 225 may be connected to the first node N1. The transistors 210, 215 may have a doping type that is complementary to a doping type of the transistors 220, 225; thus, in the example illustrated in FIG. 2, transistors 210, 215 are shown as PMOS transistors and transistors 220, 225 are shown as NMOS transistors. The cross-connected inputs of the transistors may cause the transistors 210-225 to be rendered conductive and non-conductive in alternating sets. Specifically, when a voltage at node N1 causes transistor 215 to be conductive, that same voltage would cause transistor 225 to be non-conductive and, at the same time, a voltage at node N2 would cause transistor 220 to be conductive and transistor 210 to be non-conductive. Also, when a voltage at node N2 causes transistor 210 to be conductive, that same voltage would cause transistor 220 to be non-conductive and, at the same time, a voltage at node N1 would cause transistor 215 to be non-conductive and transistor 225 to be conductive.

The inductor 230 and the capacitor 235 may be connected in parallel between the nodes N1 and N2. Thus, when transistors 210 and 225 are conductive, an active path may be established from transistor 210 to node N1, further through inductor 230 and capacitor 235 to node N2 and to transistor 225 (illustrated in FIG. 2 as Path 1). Alternatively, when 215 and 220 are conductive, another active path may be established from transistor 215 to node N1, further through inductor 230 and capacitor 235 to node N2 and to transistor 220 (path not shown in FIG. 2). Thus, the capacitor 235, the inductor 230 and the transistors 210-225 form an oscillator.

In an embodiment, the capacitor 235 need not be provided as a discrete component of the transmitter 200. Instead, the transmitter 200 may rely on a parasitic capacitance that is formed between nodes N1 and N2 by the cross-coupled transistors 210, 215, 220 and 225. In such an embodiment, the parasitic capacitance between these nodes coupled with the inductance provided by the transformer winding 230 may define an oscillation rate of the transmitter 200.

Optionally, the transmitter 200 may include a current limiting transistor 255 connected between a voltage supply $V_{DD}$ and the two transistors 210, 215. The current limiting transistor 255 may be connected to a predetermined bias voltage, shown as ground in the example of FIG. 2. As its name implies, the current limiting transistor 255 may limit the amount of current that is sourced to the oscillator when it is active. By limiting the current sourced into the oscillator, the current limiting transistor may improve common mode transient immunity of the isolator system.

FIG. 2 (b) illustrates exemplary signals that may be generated during operation of the transmitter 200 in response to a binary input signal INPUT. In one state, shown as an "OFF" state, the INPUT signal may render its associated transistor 245 non-conductive, which in an ideal case may prevent current from flowing through any of the transistors 210-225. In this first state, the transmitter 200 would not drive a signal to the isolator 240.

In another state, shown as an "ON" state, the INPUT signal may render transistor 245 conductive, which may permit the transistors 210-225, inductor 230 and capacitor 235 to oscillate. Specifically, current may be allowed to flow between a first pair of transistors (say, transistors 210 and 225). The current may flow through the inductor 230 and may charge the capacitor 235. Eventually, voltages may be built up at the nodes N1, N2 that render the transistors 210, 225 non-conductive and begin to render the transistors 215, 220 conductive. This changing state of the transistors 210-225 may reverse orientation of the voltages built up in the inductor 230 and capacitor 235. The transmitter 200 may oscillate during operation, with the transistor pairs 210, 225 and 215, 220, becoming conductive and non-conductive in alternating fashion, as long as the INPUT signal remains in the ON state. The transmitter circuit 200 may drive an oscillating signal onto the inductor 230, which may drive the signal to a second winding 250 of the isolator 240. Such operation may continue for as long as the INPUT signal remains in the ON state.

The circuit design of FIG. 2 advantageously uses inductive properties of an isolator device to generate an oscillating signal that will be transmitted across an isolation barrier in an OOK system. As compared to other designs, which may provide an inductor-capacitor (LC) oscillator that is separate from the isolator, the transmitter 200 of FIG. 2 achieves an OOK system with a smaller device count and reduced area. Inductors and transformer windings oftentimes are the most area intensive circuitry when LC circuits are manufactured as integrated circuits. Accordingly, the embodiment of FIG. 2 can achieve large area savings in such devices.

The oscillating inductor signal illustrated in FIG. 2 represents an idealized response of the transmitter 200 with an instantaneous generation and termination of oscillating signals in response to transitions of the INPUT signal. In practice, however, such circuits require time to build up the inductor signal to a full swing signal. Moreover, these circuits also require time to transition from full-swing oscillation to an inactive state. Thus, the inductor signal likely will deviate from the simulation illustrated in FIG. 2 when the transmitter 200 is fabricated in an integrated circuit.

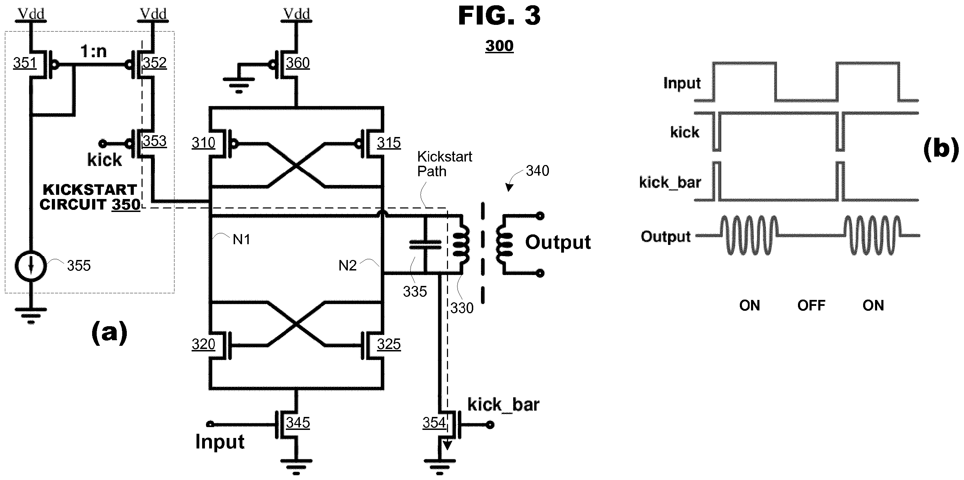

FIG. 3 (a) illustrates a transmitter 300 according to an embodiment of the present invention. The transmitter 300 may include a first pair of cross-coupled transistors 310, 315, a second pair of cross-coupled transistors 320, 325, an inductor 330 and a capacitor 335. The inductor 330 may be provided as a first winding 330 of a transformer 340 that forms the isolator 120 (FIG. 1) of the system. The transmitter 300 also may include a fifth transistor 345 for an input signal INPUT and a "kickstart" circuit 350.

Two transistors 310 and 320 may be connected together at a first node N1. The other two transistors 315, 325 may be connected together at a second node N2. Gates of the transistors 310, 320 may be connected to the second node and gates of the transistors 315, 325 may be connected to the first node N1. The transistors 310, 315 may have a doping type that is complementary to a doping type of the transistors 320, 325; thus, in the example illustrated in FIG. 3, transistors 310, 315 are shown as PMOS transistors and transistors 320, 325 are shown as NMOS transistors. The cross-connected inputs of the transistors may cause the transistors 310-325 to be rendered conductive and non-conductive in alternating sets. Specifically, when a voltage at node N1 causes transistor 315 to be conductive, that same voltage would cause transistor 325 to be non-conductive and, at the same time, a voltage at node N2 would cause transistor 320 to be conductive and transistor 310 to be non-conductive. Also, when a voltage at node N2 causes transistor 310 to be conductive, that same voltage would cause transistor 320 to be non-conductive and, at the same time, a voltage at node N1 would cause transistor 315 to be non-conductive and transistor 325 to be conductive. The capacitor 335, the inductor 330 and the transistors 310-325 may form an oscillator.

In an embodiment, the capacitor 335 need not be provided as a discrete component of the transmitter 300. Instead, the transmitter 300 may rely on a parasitic capacitance that is formed between nodes N1 and N2 by the cross-coupled transistors 310, 315, 320 and 325. In such an embodiment, the parasitic capacitance between these nodes, coupled with the inductance provided by the transformer winding 330, may define an oscillation rate of the transmitter 300.

Optionally, the transmitter 300 may include a current limiting transistor 360 connected between a voltage supply $V_{DD}$ and the two transistors 310, 315. The current limiting transistor 360 may be connected to a predetermined bias voltage, shown as ground in the example of FIG. 3. As its name implies, the current limiting transistor 360 may limit the amount of current that is sourced to the oscillator when it is active. By limiting the current sourced into the oscillator, the current limiting transistor may improve common mode transient immunity of the isolator system.

The kickstart circuit 350 may include a current mirror made of a pair of transistors 351, 352, a pair of control transistors 353, 354 and a current source 355. One of the control transistors 353 may be coupled to a first node N1 of the transmitter 300 and the second control transistor 354 may be coupled to the other node N2 of the transmitter 300. The current source 355 may be coupled to a first transistor 351 in the current mirror and the second transistor 352 may be coupled to one of the control transistors 353.

The control transistors 353, 354 may be controlled by a "kick" control signal, shown in FIG. 3(b) as kick and kick_bar. Transistor 353 is illustrated as a PMOS transistor, which may become conductive when the kick signal is low. Transistor 354 is illustrated as an NMOS transistor, which may become conductive when the kick_bar signal is high. The kick/kick_bar control signals may become active during a transition of the INPUT signal from an OFF state to an ON state. Thus, the kickstart circuit 350 may supply current to the oscillator during a transition from the OFF state to the ON state.

Consider the transmitter 300 during operation, when the oscillator has been in the OFF state for a prolonged period of time relative to its LC time constant. During such time, the capacitor 335 and inductor 330 likely store no energy. In the absence of contribution of the kickstart circuit, when the INPUT signal transitions from an OFF state to an ON state, the capacitor 335 and inductor 330 each would be charged by the voltage supply $V_{DD}$ provided through transistors 310 or 315. The time spent to charge the capacitor 335 and/or inductor 330 would increase the latency of signal transmission across the isolator boundary, which can slow throughput of the system.

In the embodiment of FIG. 3, however, the kickstart circuit 350 may become active at the transition of the INPUT signal. Thus, the kickstart circuit 350 may supply current to the oscillator via a "Kickstart Path," which extends from control transistor 353, across the inductor 330 and capacitor 335 to the second control transistor 354. As its name implies, the current supplied by the kickstart circuit 350 may kick start operation of the oscillator. It may provide a current pulse to the oscillator to speed up the oscillator's rate of charge at start up. In this manner, the oscillator may build up to full swing operation faster than in other transmitter systems, which decreases latency of the transmitter and speeds up operation of the system as a whole.

In one embodiment, the mirror transistors 351, 352 may be mismatched transistors. That is, the size of the second mirror transistor 352, the one that feeds current to other components of the transmitter 300, may be larger than the first transistor 351 (shown as N times larger than transistor 351). Thus, the amount of current driven by the current source 355 and the size ratio of the transistors 351 and 352 may determine an amount of current that the kickstart circuit 350 furnishes to the other components of the transmitter 300. Circuit designers may tailor the amount of current that is delivered to the oscillator at start up by tuning the current source 355, the ratio of transistors 351 and 352 and the duration of the kickstart signal to individual application needs.

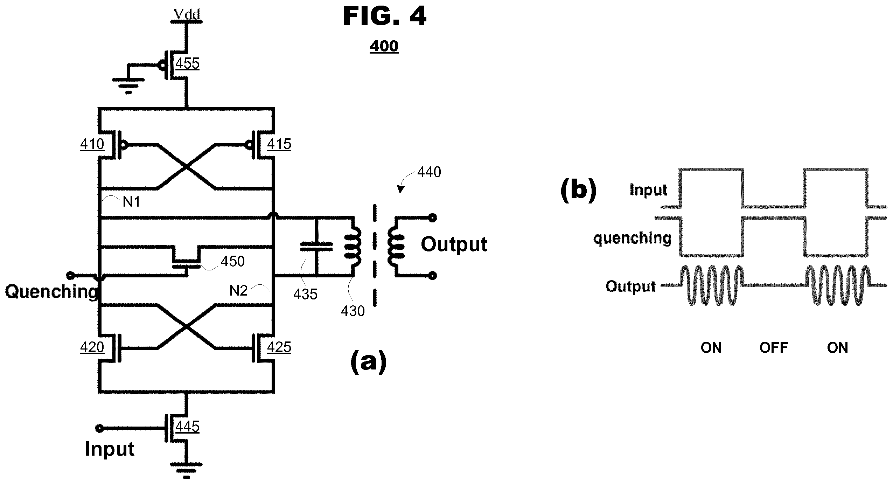

FIG. 4 (a) illustrates a transmitter 400 according to an embodiment of the present invention. The transmitter 400 may include a first pair of cross-coupled transistors 410, 415, a second pair of cross-coupled transistors 420, 425, an inductor 430 and a capacitor 435. The inductor 430 may be provided as a first winding of a transformer 440 that forms the isolator 120 (FIG. 1) of the system. The transmitter 400 also may include a fifth transistor 445 for an input signal INPUT and a sixth transistor 450, called a "quenching" transistor.

Two transistors 410 and 420 may be connected together at a first node N1. The other two transistors 415, 425 may be connected together at a second node N2. Gates of the transistors 410, 420 may be connected to the second node and gates of the transistors 415, 425 may be connected to the first node N1. The transistors 410, 415 may have a doping type that is complementary to a doping type of the transistors 420, 425; thus, in the example illustrated in FIG. 4, transistors 410, 415 are shown as PMOS transistors and transistors 420, 425 are shown as NMOS transistors. The cross-connected inputs of the transistors may cause the transistors 410-425 to be rendered conductive and non-conductive in alternating sets. Specifically, when a voltage at node N1 causes transistor 415 to be conductive, that same voltage would cause transistor 425 to be non-conductive and, at the same time, a voltage at node N2 would cause transistor 420 to be conductive and transistor 410 to be non-conductive. Also, when a voltage at node N2 causes transistor 410 to be conductive, that same voltage would cause transistor 420 to be non-conductive and, at the same time, a voltage at node N1 would cause transistor 415 to be non-conductive and transistor 425 to be conductive. The capacitor 435, the inductor 430 and the transistors 410-425 may form an oscillator.

The inductor 430, the capacitor 435 and the quenching transistor 450 may be connected in parallel between the nodes N1 and N2. When the quenching transistor 450 is conductive, it shorts nodes N1 and N2 together. When the quenching transistor 450 is non-conductive, it permits the transistors 410-425, capacitor 435 and inductor 430 to oscillate as discussed in the foregoing embodiments. Specifically, transistors 410 and 425 may be conductive and form an active path from transistor 410 to node N1, further through inductor 430 and capacitor 435 to node N2 and to transistor 425. And, in another portion of oscillation, transistors 415 and 420 may form another active path from transistor 415 to node N1, further through inductor 430 and capacitor 435 to node N2 and to transistor 420.

As indicated, the quenching transistor 450 may short nodes N1 and N2 together when it is rendered conductive. The quenching transistor 450, therefore, may facilitate transition from an ON state to an OFF state by providing a low-impedance path that dissipates energy that may be stored in the inductor 430 and/or capacitor 435. Increasing the speed of transition from an ON state to an OFF state may reduce latency of transitions as they are communicated across the isolation barrier and, therefore, may improve throughput as a whole.

In an embodiment, the capacitor 435 need not be provided as a discrete component of the transmitter 400. Instead, the transmitter 400 may rely on a parasitic capacitance that is formed between nodes N1 and N2 by the cross-coupled transistors 410, 415, 420 and 425. In such an embodiment, the parasitic capacitance between these nodes, coupled with the inductance provided by the transformer winding 430, may define an oscillation rate of the transmitter 400.

Optionally, the transmitter 400 may include a current limiting transistor 455 connected between a voltage supply $V_{DD}$ and the two transistors 410, 415. The current limiting transistor 455 may be connected to a predetermined bias voltage, shown as ground in the example of FIG. 4. As its name implies, the current limiting transistor 455 may limit the amount of current that is sourced to the oscillator when it is active. By limiting the current sourced into the oscillator, the current limiting transistor may improve common mode transient immunity of the isolator system.

FIG. 4 (b) illustrates exemplary signals that may find application in the transmitter 400 of FIG. 4 (a). In the illustrated embodiment, the quenching transistor 450 is shown as an NMOS transistor that is rendered conductive in response to a control signal (called "QUENCHING") at a high voltage level. Other embodiments may use different types of transistors (say, a PMOS transistor) that are rendered conductive in response to a low control signal.

The QUENCHING signal is illustrated as transitioning high during a transition from an ON state to an OFF state of the oscillator. When this occurs, the quenching transistor 450 is rendered conductive, which shorts nodes N1 and N2 together. This shorts the plates of capacitor 435 together and the terminals of inductor 430 together, which causes the energy dissipation described above. In this manner, the oscillating OUTPUT signal is dampened quickly.

In the embodiment illustrated in FIG. 4 (b), the QUENCHING signal is illustrated as active for the full duration of the INPUT signal. In such an embodiment, the QUENCHING signal may be provided as an inversion of the INPUT signal (essentially, input_bar). In other embodiments, the active period of the QUENCHING signal may be set shorter than the full duration of the INPUT signal if desired, so long as the active period has a sufficient duration to dissipate energy of the inductive and capacitive elements within the transmitter.

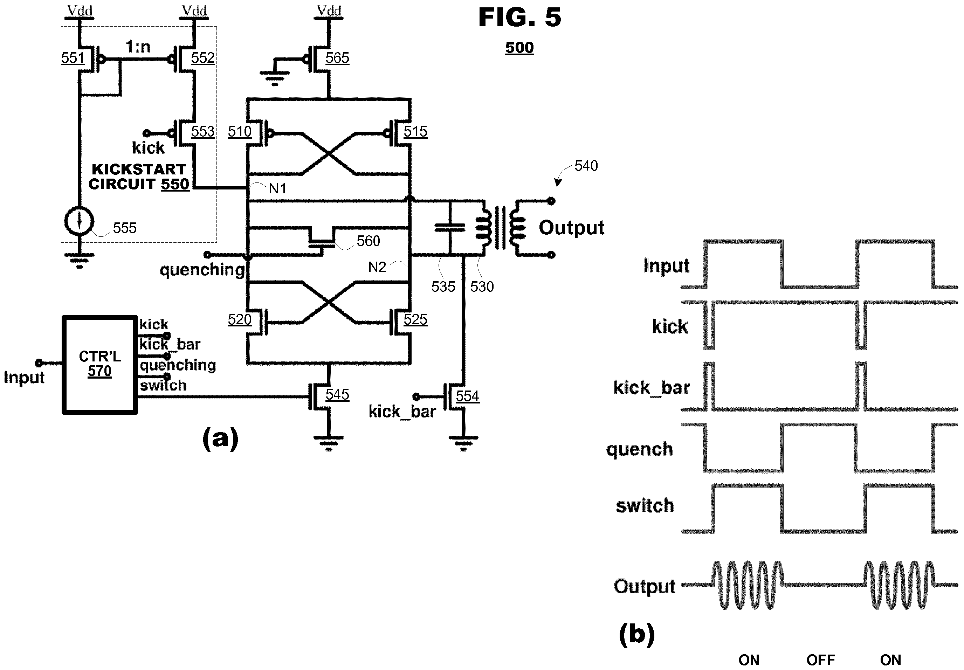

The principles of FIGS. 3 and 4 may be integrated into a common transmitter, as shown in the embodiment of FIG. 5. There, a transmitter 500 may include a first pair of cross-coupled transistors 510, 515, a second pair of cross-coupled transistors 520, 525, an inductor 530 and a capacitor 535. The inductor 530 may be provided as a first winding of a transformer 540 that forms the isolator 120 (FIG. 1) of the system. The transmitter 500 also may include a fifth transistor 545 for a mode control signal (shown as "SWITCH"), a kickstart circuit 550, a quenching transistor 560 and a controller 570.

Two transistors 510 and 520 may be connected together at a first node N1. The other two transistors 515, 525 may be connected together at a second node N2. Gates of the transistors 510, 520 may be connected to the second node and gates of the transistors 515, 525 may be connected to the first node N1. The transistors 510, 515 may have a doping type that is complementary to a doping type of the transistors 520, 525; thus, in the example illustrated in FIG. 5, transistors 510, 515 are shown as PMOS transistors and transistors 520, 525 are shown as NMOS transistors. The cross-connected inputs of the transistors may cause the transistors 510-525 to be rendered conductive and non-conductive in alternating sets. Specifically, when a voltage at node N1 causes transistor 515 to be conductive, that same voltage would cause transistor 525 to be non-conductive and, at the same time, a voltage at node N2 would cause transistor 520 to be conductive and transistor 510 to be non-conductive. Also, when a voltage at node N2 causes transistor 510 to be conductive, that same voltage would cause transistor 520 to be non-conductive and, at the same time, a voltage at node N1 would cause transistor 515 to be non-conductive and transistor 525 to be conductive. The capacitor 535, the inductor 530 and the transistors 510-525 may form an oscillator.

The inductor 530, the capacitor 535 and the quenching transistor 560 may be connected in parallel between the nodes N1 and N2. When the quenching transistor 560 is conductive, it shorts nodes N1 and N2 together. When the quenching transistor 560 is non-conductive, it permits the transistors 510-525, capacitor 535 and inductor 530 to oscillate as discussed in the foregoing embodiments. Specifically, transistors 510 and 525 may be conductive and form an active path from transistor 510 to node N1, further through inductor 530 and capacitor 535 to node N2 and to transistor 525. And, in another portion of oscillation, transistors 515 and 520 may form another active path from transistor 515 to node N1, further through inductor 530 and capacitor 535 to node N2 and to transistor 520.

The kickstart circuit 550 may include a current mirror made of a pair of transistors 551, 552, a pair of control transistors 553, 554 and a current source 555. One of the control transistors 553 may be coupled to a first node N1 of the transmitter 500 and the second control transistor 554 may be coupled to the other node N2 of the transmitter 500. The current source may be coupled to a first transistor 551 in the current mirror and the second transistor 552 may be coupled to one of the control transistors 553.

In an embodiment, the capacitor 535 need not be provided as a discrete component of the transmitter 500. Instead, the transmitter 500 may rely on a parasitic capacitance that is formed between nodes N1 and N2 by the cross-coupled transistors 510, 515, 520 and 525. In such an embodiment, the parasitic capacitance between these nodes, coupled with the inductance provided by the transformer winding 530, may define an oscillation rate of the transmitter 500.

Optionally, the transmitter 500 may include a current limiting transistor 565 connected between a voltage supply $V_{DD}$ and the two transistors 510, 515. The current limiting transistor 565 may be connected to a predetermined bias voltage, shown as ground in the example of FIG. 5. As its name implies, the current limiting transistor 565 may limit the amount of current that is sourced to the oscillator when it is active. By limiting the current sourced into the oscillator, the current limiting transistor may improve common mode transient immunity of the isolator system.

The control transistors 553, 554 may be controlled by a kick control signal, shown in FIG. 5(b) as "kick" and "kick_bar." The control transistor 553 is illustrated as a PMOS transistor, which may become conductive when the kick signal is low. The control transistor 554 is illustrated as an NMOS transistor, which may become conductive when the kick_bar signal is high. The kick/kick_bar control signals may become active during a transition of the MODE signal from an OFF state to an ON state. Thus, the kickstart circuit 550 may supply current to the oscillator during a transition from the OFF state to the ON state.

The controller 570 may generate control signals to the kickstart circuit 550, the quenching transistor 560 and the switch transistor 545. FIG. 5(b) illustrates an exemplary set of such signals. Consider a situation where the input signal transitions from a low voltage level to a high voltage level. Before the transition of the input signal, the kick signal may be inactive (kick is set to a high voltage level and kick_bar is set to a low voltage level) and the quench signal may be set to an active level. In response to these signals, the kick control transistors 553 and 554 may be non-conductive and the quenching transistor 560 may be conductive.

When the input signal transitions from the low voltage to the high voltage, the controller 570 may deactivate the quenching signal and trigger the kick and kick_bar signals. Deactivation of the quenching signal may cause the quenching transistor to become non-conductive, severing the low impedance pathway between nodes N1 and N2. Activation of the kick and kick_bar signals may cause the kickstart circuit 500 to supply current to the inductor 530 and capacitor 535, which may begin oscillation. The kickstart circuit 550 may continue to supply current for a time during which the kick and kick_bar signal are active.

At the conclusion of the kickstart pulse duration, the controller 570 may deactivate the kick and kick_bar signals and activate the switch signal. Deactivation of the kick and kick_bar signals may cause the control transistors 553 and 554 to become non-conductive which prevents the kickstart circuit 500 from supplying further current to the oscillator. Activation of the SWITCH signal may cause the switch transistor 545 to become conductive, which may cause the oscillator to engage in normal operation. That is, oscillator operation may be governed by switching operation of transistors 510-525 as discussed above in 0. Oscillating operation may continue in this manner until the controller 570 changes state of the SWITCH signal, which may occur on a falling transition of the INPUT signal.

When the INPUT signal falls from a high voltage level to a low voltage level, the transmitter 500 should be in an OFF state. The controller 570 may deactivate the SWITCH signal and activate the QUENCH signal in response to a falling transition of the INPUT signal. Deactivation of the SWITCH signal may cause transistor 545 to become non-conductive, which may disable current flow between the current supplies $V_{DD}$ and ground. Activation of the QUENCH signal may cause the quenching transistor 560 to become conductive, which may dissipate energy that is stored in the capacitor 535 and the inductor 530. The controller 570 may maintain the transmitter 500 in the OFF state until a rising transition occurs in the INPUT signal, whereupon the controller 570 may activate the kick and kick_bar signals and deactivate the quenching signal as discussed above.

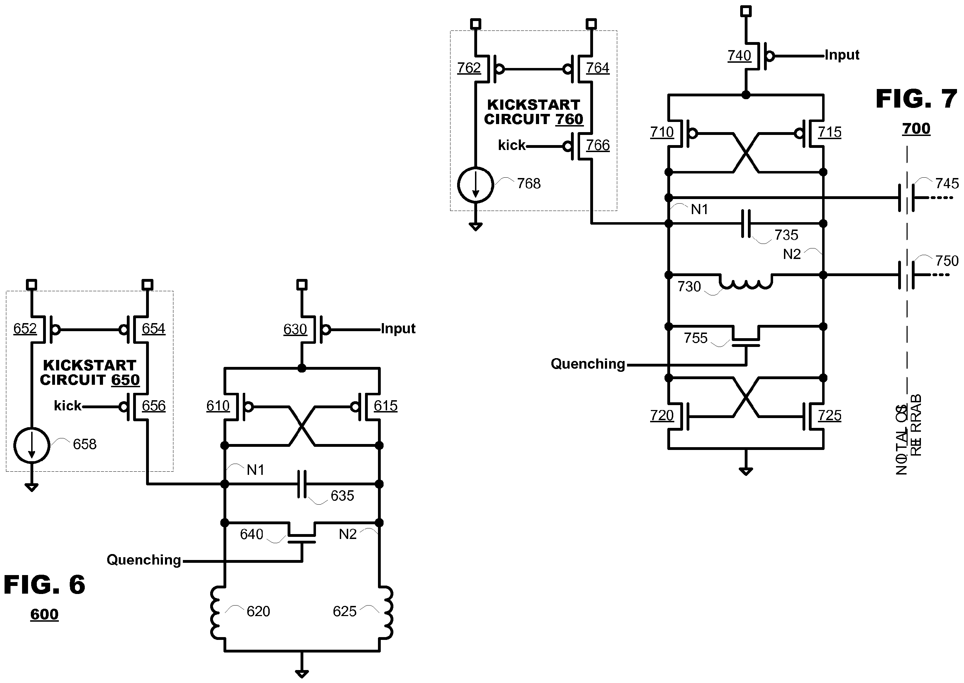

The principles of the present invention also find application in a transmitter architecture that uses only two pairs of cross-coupled transistors in an oscillator. FIG. 6 illustrates such an embodiment. There, an oscillator may be formed by a pair of cross-coupled transistor 610, 615, a pair of inductors 620, 625 and a capacitor 635. Again, in certain embodiments, the capacitor 635 may be a virtual device formed from parasitic capacitances provided by the transistors 610, 615. A transistor 630 may be connected between the oscillator and one of the voltage supplies ($V_{DD}$ in this example).

In this example, a quenching transistor 635 may be provided between a pair of nodes N1, N2 from which the cross-coupled transistors take their inputs (across the capacitance 635). It may become active to facilitate transition from an ON state to an OFF state. A kick start circuit 650 may be connected to one of the nodes (N1) and may inject current into the oscillator to facilitate transition from an OFF state to an ON state. The oscillator signal may be capacitively coupled from the nodes N1 and N2 (like in Figure 7), or one or both of the inductors may form part of a transformer circuit to act as the isolation barrier.

As discussed, the principles of the present invention also find application with different types of isolator devices. FIG. 7 illustrates a transmitter 700 that may find application in an embodiment having capacitor-based isolators. In this embodiment, the transmitter 700 may include an oscillator formed from two pairs of cross-coupled transistors 710, 715, 720 and 725, an inductor 730 and a capacitor 735. The inductor 730 and capacitor 735 may be coupled between nodes N1 and N2 at which the inputs of the cross-coupled transistor 710, 715, 720 and 725 may take their inputs. A transistor 740 may be coupled between a voltage supply (VDD, in this example) and the oscillator and may take its input from the input signal to be transmitted by the transmitter 700.

The isolator devices 745, 750, in this embodiment, may be capacitors. A first terminal of the first capacitor 745 may be coupled to one of the nodes N1 and a first terminal of the second capacitor 750 may be coupled to a second one of the nodes N2. Second terminals of the capacitors 745, 750 may be provided on an opposite side of an isolation barrier from a side in which the transmitter 700 is located.

FIG. 7 illustrates application of a quenching transistor 755 and a kick start circuit 760 to this embodiment. The quenching transistor 755 may be provided between the nodes N1, N2 from which the cross-coupled transistors take their inputs (across the capacitance 735). It may become active to facilitate transition from an ON state to an OFF state. A kickstart circuit 760 may be connected to one of the nodes (N1) and may inject current into the oscillator to facilitate transition from an OFF state to an ON state.

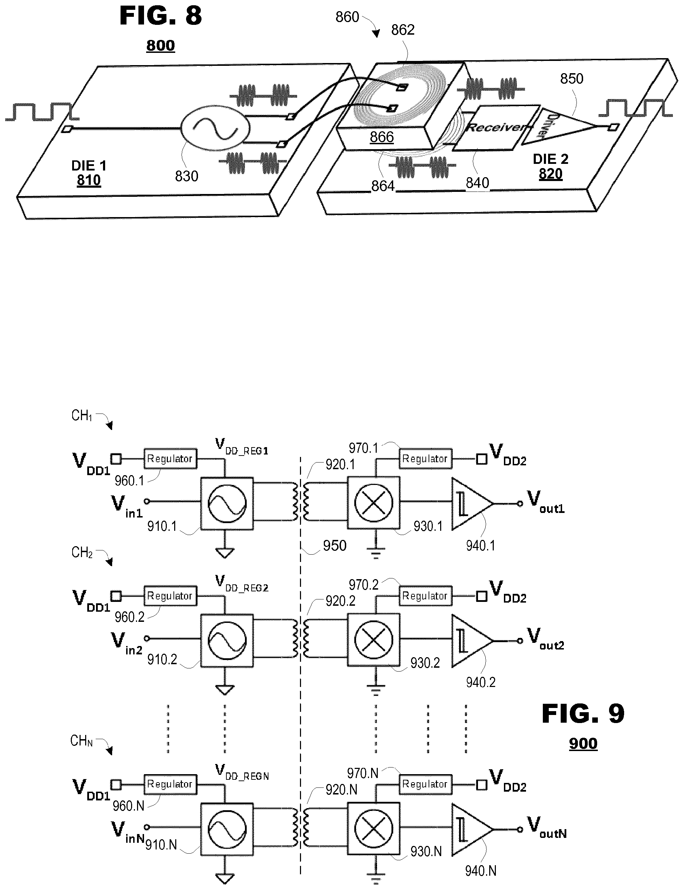

FIG. 8 is a schematic diagram illustrating a circuit arrangement for signal isolator system 800 according to an embodiment of the present invention. There, the isolator system 800 may include a pair of semiconductor dies 810, 820 each galvanically isolated from the other. As discussed, the dies each may have their own voltage supplies and ground references. In the example of FIG. 8, the first die 810 may include a transmitter 830, and the second die 820 may include a receiver 840 and an output driver 850. The transmitter 830 and receiver 840 may be separated by an isolation device 860 formed of a first winding 862 and a second winding 864 separated by a dielectric layer 866. The second winding 864 may form part of the receiver 840 and may be provided in the second die 820 with the receiver 840. The first winding 862 may form part of the transmitter 830 and may be provided over the second die 820 in proximity to the second winding 864. The dielectric layer 866 may define the isolation barrier between the first and second dies; a breakdown voltage of the dielectric layer 866 may determine how much isolation protection is afforded by the signal isolator system 800. The first die and the second die are provided in an integrated circuit package (a shared package).

As shown in FIG. 9, the signal isolator system may be replicated to provide additional channels $CH_1$-$CH_N$ of communication between the dies. First, individual channels $CH_1$, $CH_2$, ..., $CH_N$ of transmitter-receivers may be replicated in a first orientation for transmission of data in a first direction (illustrated as left to right transmission in FIG. 9) across an isolation barrier 950. Replication of the channels CH1-CH2 may provide multiple channels of unidirectional communication from the first die 810 to the second die 820 (FIG. 8). Additionally, such channels may be replicated and reversed in orientation (right to left signal transmission) to provide one or more channels of unidirectional communication from the second die 820 to the first die 810 (channels not shown). Such implementations are within the scope of the present invention.

In such embodiments, each of the channels $CH_1$, $CH_2$, ..., $CH_N$ may include a respective transmitter 910.1-910.N, isolator 920.1-920.N, receiver 930.1-930.N and output driver 940.1-940.N. The isolators 920.1-920.N may span an isolation boundary 950, which galvanically isolates two voltage domains from each other. The transmitters 910.1-910.N may generate OOK output signals from the input signals $V_{IN1}$-$V_{INN}$ and deliver them to their respective isolators 920.1-920.N. The receivers 930.1-930.N may generate an OOK current signal from the signals supplied to them by their respective isolators 920.1-920.N. The output driver 940.1-940.N may generate a binary voltage signal from the current signal supplied to it by their respective receivers 930.1-930.N. Thus, multiple signal channels $CH_1$, $CH_2$, ..., $CH_N$ may communicate data from a first side of an isolation barrier 950 to a second side. The channel structures may be replicated and reversed in orientation to communicate signals from the second side of the isolation barrier 950 to the first side.

In an embodiment, the channels $CH_1$-$CH_N$ may include voltage regulators 960.1-960.N and 970.1-970.N provided on the transmitter-side of the channels, on the receiver-side of the channels or both. These regulators may lower supply voltages ($V_{DD1}$, $V_{DD2}$) to the respective transmitter, receiver components to save power and to minimize oscillator amplitude variations across power supply ranges. In some applications, oscillator operations can generate "ripples" in supply voltages within the transmitters 910.1-910.N and/or receivers 930.1-930.N; the presence of voltage regulators 960.1-960.N and 970.1-970.N can mitigate such effects in the voltage supplies $V_{DD1}$ and $V_{DD2}$ which can reduce cross-talk effects that may occur between channels.

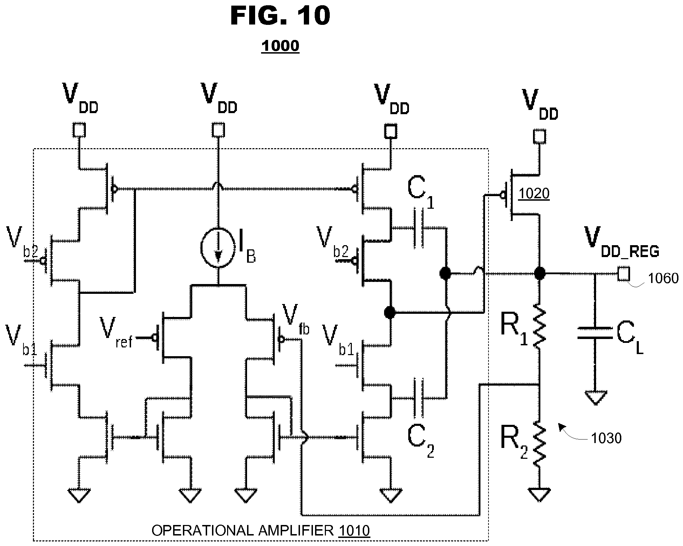

FIG. 10 illustrates a circuit diagram of a voltage regulator 1000 according to an embodiment of the present invention. The voltage regulator 1000 may include an operational amplifier (also "op amp") 1010, a supply transistor 1020, a voltage divider 1030 and a load capacitor $C_L$. The voltage regulator 1000 may have an output terminal 1040 that may be connected to other circuit elements, for example, a transmitter or receiver of the foregoing embodiments.

The op amp 1010 may have inputs for a reference voltage Vref and for a feedback voltage Vfb that is generated by the voltage divider 1030. An output of the op amp 1010 may be coupled to a gate of the supply transistor 1020. The op amp 1010 may include capacitors C1 and C2 that are integrated within an integrated circuit in which the op amp 1010 is manufactured. An output node 1060 of the regulator 1000 may be coupled to an intermediate node in a current path to which the capacitors C1 and C2 are coupled.

The voltage regulator 1000 may operate to keep a voltage VDD_REG at an output node 1040 at a predetermined level. The supply transistor 1020 and the load capacitor $C_L$ may be coupled between a supply voltage VDD and the output node 1040. The voltage divider 1030 may be coupled between a second supply voltage (ground) and the output node 1040. The voltage divider 1030 may be provided as a pair of series-connected elements having impedances R1 and R2. The impedance elements may be provided as resistors, biased transistors or other devices having predetermined impedances

At steady state operating conditions, the op amp 1010 may operate to maintain a voltage at an intermediate node within the voltage divider 1030 at a level that matches Vref (e.g., $V_{fb}=V_{ref}$). The voltage at the output node may be maintained at a voltage as

$$\mathrm{VDD\_REG} = \frac{R_1+R_2}{R_2}V_{fb}.$$

The load capacitor CL may be charged to this level VDD_REG. The supply transistor 1020 may be controlled to source operating current to a load device (not shown) via the output node 1040.

When transients occur, a load device (not shown) either may pull or may push current to the output node 1040. When a transient causes a pull of current from the output node, such current may be sourced by the load capacitor CL and capacitors C1 and C2, which will help force the transistors 1404 to be more conductive to supply that current. In this manner, such transients are less likely to be passed back to voltage supply circuitry (not shown) that sources VDD. When a transient causes a push of current to the output node, such current may cause a voltage pushback, via the capacitors C1 and C2 to the gate of the supply transistor 1020. The supply transistor 1020 may become less conductive than at steady state operation, which may insulate the voltage supply circuitry (not shown) that sources VDD from the transient effect of the current push. Accordingly, the voltage regulator 1000 may immunize (to a degree) voltage supply circuitry from transient effects that otherwise might be imposed by changing operating conditions of a transmitter or a receiver.

As illustrated in FIG. 1, the transmitters of the foregoing embodiments may be used cooperatively with a receiver 130 that operates in a separate voltage domain that is isolated from a voltage domain of the transmitter 110 by an isolation boundary 150. Exemplary receivers are illustrated in a co-pending application, filed on even date herewith, entitled "Demodulation of On-Off-Key Modulated Signals in Signal Isolator Systems," s.n. 14/486,951 (attorney docket 13641/518201), the disclosure of which follows here.

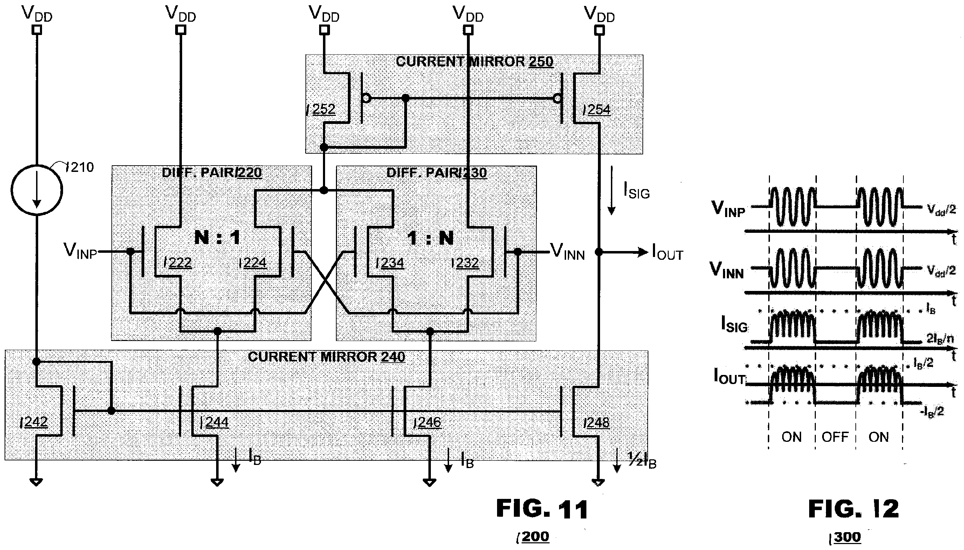

FIG. 11 illustrates a receiver 1200 according to an embodiment of the present invention, which may be employed as a receiver in the system of FIG. 1. The receiver 1200 may include a current source 1210, two differential pair circuits 1220, 1230 and a pair of current mirrors 1240, 1250.

The differential pair circuits 1220, 1230 each may include a pair of mismatched transistors 1222, 1224 for pair 1220 and 1232, 1234 for pair 1230. The transistors in each pair 1220, 1230 may be mismatched according to a predetermined sizing ratio, shown as N to 1. Thus, transistors 1222 and 1232 may be N times larger than their counterpart transistors 1224 and 1234. During operation, in response to a common control voltage, the transistors 1222, 1232 may pass N times more current than the counterpart transistors 1224 and 1234.

The input signal $V_{IN}$ may be a differential signal represented by component signals $V_{INN}$ and $V_{INP}$. Gates of transistors 1222 and 1234 may receive a first input voltage $V_{INP}$ and gates of the other transistors 1224 and 1232 may receive a second input voltage $V_{INN}$. Sources of the transistors 1222, 1224 in the first differential pair 1220 may be connected to a common node, which may be coupled to a transistor 1244 within the current mirror 1240. Sources of the transistors 1232, 1234 in the second differential pair 1230 may be connected to a second node, which may be coupled to another transistor 1246 within the current mirror 1240. Drains of the unit-sized transistors 1224, 1234 of the two differential pairs 1220, 1230 may be connected together and connected to a first transistor 1252 in the second current mirror 1250. Drains of the N-sized transistors 1222, 1232 of the two differential pairs 1220, 1230 may be connected to voltage supplies $V_{DD}$.

The first current mirror 1240 may include a plurality of transistors 1242-1248 whose gates are connected together. The first transistor 1242 may be connected to the current source 1210 at its drain. The first transistor 1242 also may be configured in a diode-connected configuration. Thus, an amount of current that passes through the first transistor 1242 (which is defined by the current source 1210) defines the amount of current that passes through the remaining transistors 1244-1248 of the current mirror 1240. The transistors 1244-1248 may be sized so that twice as much current passes through transistors 1244 and 1246 as passes through transistor 1248 (shown as $I_B$ and $\frac{1}{2}I_B$, respectively).

The second current mirror 1250 may include a pair of transistors 1252 and 1254. As discussed, a first transistor 1252 may be connected to the unit-sized transistors 1224 and 1234 of the differential pairs 1220, 1230. The second transistor 1254 may be connected to the transistor 1248 in the first current mirror 1240. The first transistor 1252 may be provided in a diode-connected configuration. Thus, the current that passes through transistor 1252 defines an amount of current that passes through transistor 1254.

An output terminal $I_{OUT}$ of the receiver 1200 may be provided at the connection between transistors 1254 and 1248. During operation, the transistors 1254 and 1248 perform a current comparison at the output terminal $I_{OUT}$. The transistor 1248 may sink an amount of current from the output terminal equal to $\frac{1}{2}I_B$. The transistor 1254 may source an amount of current $I_{SIG}$ to the output terminal in an amount that is determined by the differential pairs 1220, 1230, which in turn is determined by the input signals $V_{INP}$ and $V_{INN}$. When $I_{SIG} \neq \frac{1}{2}I_B$, a residual current is either sourced to or sunk from the output terminal $I_{OUT}$.

In the embodiment illustrated in FIG. 11, the transistors are illustrated as MOSFET transistors and, specifically, transistors 1222-1224, 1232-1234 and 1242-1248 are illustrated as NMOS transistors and transistors 1252-1254 are illustrated as PMOS transistors. The principles of the present invention apply to transistors of other process technologies, such as BJT transistors and the like. Moreover, as discussed hereinbelow, process types may be inverted (e.g., PMOS transistors may be provided where NMOS transistors are illustrated and NMOS transistors may be provided where PMOS transistors are illustrated) with appropriate inversion of supply voltages. Such variations are immaterial to the principles of the present invention unless mentioned herein.

FIG. 12 illustrates exemplary input and output signals that may be processed by the receiver of FIG. 11. The input signals $V_{INP}$ and $V_{INN}$ may toggle between two phases of operation according to the OOK signal structure of the system. In a first phase of operation, the OOK signal may be in an "OFF" state in which $V_{INP}$ and $V_{INN}$ are inactive signals. As shown in FIG. 11, $V_{INP}$ and $V_{INN}$ each have voltages of $\frac{1}{2}V_{DD}$. In the second phase of operation, the OOK signal may be in an "ON" state in which $V_{INP}$ and $V_{INN}$ are active signals. In the example of FIG. 12, the $V_{INP}$ and $V_{INN}$ signals oscillate between $V_{DD}$ and ground, centered about $\frac{1}{2}V_{DD}$. In practice, $V_{INP}$ and $V_{INN}$ may not be full rail signals (e.g., transitioning fully to ground or to $V_{DD}$) owing to losses within the circuit system.

During the OFF state, when $V_{INP}$ and $V_{INN}$ are set to $\frac{1}{2}V_{DD}$, the transistors 1222, 1224, 1232, 1234 of the differential pairs 1220, 1230 may become partially conductive. The transistors 1222, 1232 may source N times as much current to their respective transistors 1244, 1246 in the current mirror 1240 than the transistors 1224, 1234 do. The current mirror transistors 1244, 1246 each govern current through the differential pairs 1220, 1230, limiting the total current through each pair 1220, 1230 to $I_B$. Thus, transistors 1224 and 1234 each pass current in the amount of $\frac{1}{N+1}I_B$ and the transistors 1222, 1232 each pass the remainder of the current $\frac{N}{N+1}I_B$.

In the second current mirror 1250, the transistor 1252 may source the current that passes through the unit-sized transistors 1224, 1234. Thus, transistor 1252 may pass current in an amount of $\frac{2}{N+1}I_B$. This current may be replicated in transistor 1254 $\left(I_{SIG} = \frac{2}{N+1}I_B\right)$. The $I_{SIG}$ current may be compared to the current ($\frac{1}{2}I_B$) that is drained from the output terminal by transistor 1248. Thus, the output current may be represented as $I_{OUT} = \frac{2}{N+1}I_B - \frac{1}{2}I_B$. When N is sufficiently large (e.g., $N \geq 10$), these equations may simplify to:

$$I_{SIG} = \frac{2}{N}I_B,$$

and

$$I_{OUT} = -\frac{1}{2}I_B.$$

During the ON state, $V_{INP}$ and $V_{INN}$ may oscillate between $V_{DD}$ and ground. Conductivity of the transistors 1222, 1224, 1232, 1234 of the differential pairs 1220, 1230 may vary according to these signals. When $V_{INP}$ is at its maximum level, for example, transistors 1222 and 1234 may be nearly fully conductive. At this same time, $V_{INN}$ will be at its minimum level, which may render transistors 1224 and 1232 minimally conductive. Thus, transistors 1222 and 1234 each may pass nearly all of the current ($I_B$) that their associated current mirror transistors 1244 and 1246 sink. The current passed by transistor 1224 may be sourced by transistor 1252 in the second current mirror. Thus, the second transistor 1254 in the second current mirror 1250 may generate a current $I_{SIG}$ at $I_B$.

Similarly, when $V_{INN}$ is at its maximum level, for example, then transistors 1232 and 1224 may be nearly fully conductive. At this same time, $V_{INP}$ will be at its minimum level, which may render transistors 1222 and 1234 minimally conductive. Thus, transistors 1224 and 1232 each may pass nearly all of the current ($I_B$) that their associated current mirror transistors 1244 and 1246 sink. The current passed by transistor 1234 may be sourced by transistor 1252 in the second current mirror. Thus, the second transistor 1254 in the second current mirror 1250 may generate a current $I_{SIG}$ at $I_B$.

Overall, during the ON phase, the $I_{SIG}$ current may vary in response to the $V_{INP}$ and $V_{INN}$ input signals as shown in FIG. 12. The $I_{SIG}$ current may be compared to the $\frac{1}{2}I_B$ current that is sunk from the output terminal by the current mirror transistor 1248. Thus, the receiver of FIG. 11 may generate an output current $I_{OUT}$ having the form illustrated in FIG. 12.

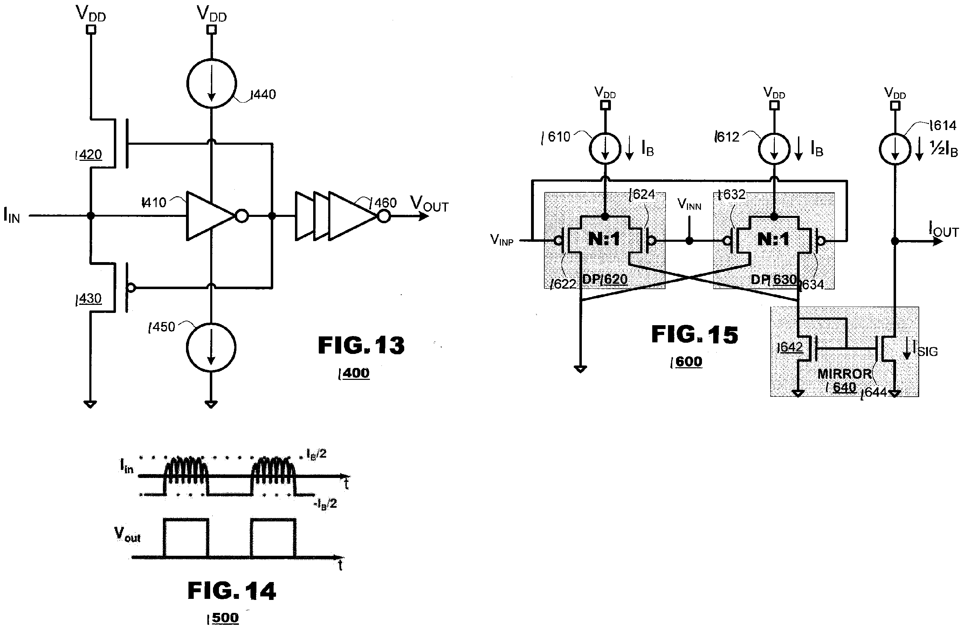

FIG. 13 illustrates a current comparator 1400 according to an embodiment of the present invention.

The comparator 1400 may include an inverter 1410, a pair of pulling transistors 1420, 1430, current sources 1440 and 450 and one or more inverters 1460. The inverter 1410 may accept a current input $I_{IN}$ on an input terminal. The input current may be an output current $I_{OUT}$ generated by a receiver such as those described in FIGS. 11, 15 and 17 of this disclosure.

The input terminal IIN also may be connected to a first supply voltage $V_{DD}$ by a first transistor 1420 and to a second supply voltage (shown as ground) by a second transistor 1430. Gates of the transistors 1420, 1430 may be coupled to an output of the inverter 1410. The transistors 1420, 1430 may provide a positive feedback control within the comparator 1400 to pull an input signal in the direction of one of the supplies $V_{DD}$ or ground as the input current $I_{IN}$ drives the inverter's input in that direction.

The inverter 1410 may be connected to the supply voltages $V_{DD}$ and ground by respective current sources 1440, 450. During operation, the current sources 1440, 450 may limit responsiveness of the inverter 1410 to transitions in the input current signal $I_{IN}$, which helps to filter signal glitches and other transients that otherwise might by introduced by noise within the system.

The inverter(s) 1460 may buffer a voltage output provided by the inverter 1410. The inverters 1460 may include filters or other signal conditioning circuits (not shown) to filter transients from the inverter's output. A voltage $V_{OUT}$ output from the inverters 1460 may be output from the isolator system as a digital output signal.

FIG. 14 illustrates exemplary input and output signals that may be processed by the comparator 1400 of FIG. 13. In FIG. 14, the input current IIN is shown as the output current signal $I_{OUT}$ in FIG. 12. The output signal generated from the input current $I_{IN}$ is shown as $V_{OUT}$.

FIG. 15 illustrates a receiver 1600 according to another embodiment of the present invention. The receiver 1600 may include a plurality of current sources 1610, 1612, 1614, two differential pair circuits 1620, 1630 and a current mirror 1640. The current sources 1610 and 1612 may supply currents to an associated differential pair circuit 1620 or 1630 at a first level $I_B$. The current source 1614 may source current to an output terminal $I_{OUT}$ at a level that is half the level of current sources 1610 and 1620 (e.g., $\frac{1}{2}I_B$).

The differential pair circuits 1620, 1630 each may include a pair of mismatched transistors 1622, 1624 for differential pair circuit 1620 and 1632, 1634 for differential pair circuit 1630. The transistors in each pair 1620, 1630 may be mismatched according to a predetermined sizing ratio, shown as N to 1. Thus, transistors 1622 and 1632 may be N times larger than their counterpart transistors 1624 and 1634. During operation, in response to a common control voltage, the transistors 1622, 1632 may pass N times more current than the counterpart transistors 1624 and 1634.

The input signal $V_{IN}$ may be a differential signal represented by component signals $V_{INN}$ and $V_{INP}$. Gates of transistors 1622 and 1634 may receive a first input voltage $V_{INP}$ and gates of the other transistors 1624 and 1632 may receive a second input voltage $V_{INN}$. Sources of the transistors 1622, 1624 in the first differential pair circuit 1620 may be connected to a common node, which may be coupled to current source 1610. Sources of the transistors 1632, 1634 in the second differential pair 1630 may be connected to a second node, which may be coupled to another current source 1620. Drains of the unit-sized transistors 1624, 1634 of the two differential pair circuits 1620, 1630 may be connected together and connected to a first transistor 1642 in the second current mirror 1640. Drains of the N-sized transistors 1622, 1632 of the two differential pair circuits 1620, 1630 may be connected to a voltage supply (ground, in this case).

The current mirror 1640 may include a pair of transistors 1642 and 1644. As discussed, a first transistor 1642 may be connected to the unit-sized transistors 1624 and 1634 of the differential pairs 1620, 1630. The second transistor 1644 may be connected to the current source 1614. The first transistor 1642 may be provided in a diode-connected configuration. Thus, the current that passes through transistor 1642 defines an amount of current that passes through transistor 1644.

An output terminal $I_{OUT}$ of the receiver 1600 may be provided at the connection between transistors 1644 and current source 1614. During operation, the transistor 1644 and current source 1614 perform a current comparison at the output terminal $I_{OUT}$. The current source 1614 may source an amount of current to the output terminal equal to $\frac{1}{2}I_B$. The transistor 1644 may sink an amount of current $I_{SIG}$ from the output terminal $I_{OUT}$ in an amount that is determined by the differential pair circuits 1620, 1630, which in turn is determined by the input signals $V_{INP}$ and $V_{INN}$. When $I_{SIG} \neq \frac{1}{2}I_B$, a residual current is either sourced to or sunk from the output terminal $I_{OUT}$.

The circuit of FIG. 15 may operate in accordance with the principles discussed above with respect to FIG. 12. Here, the transistors 1622-1624, 1632-1634 of the differential pairs 1620, 1630 are illustrated as PMOS transistors rather than NMOS transistors as illustrated in FIG. 11 and, therefore, the conductivity of the transistors will be inverted from that of the FIG. 11 circuit during the ON phase. Nevertheless, the circuit of FIG. 15 may generate a signal current $I_{SIG}$ as illustrated in FIG. 12, which may be compared to the current $\frac{1}{2}I_B$ of the current source 1614 to generate the $I_{OUT}$ signal, also illustrated in FIG. 12.

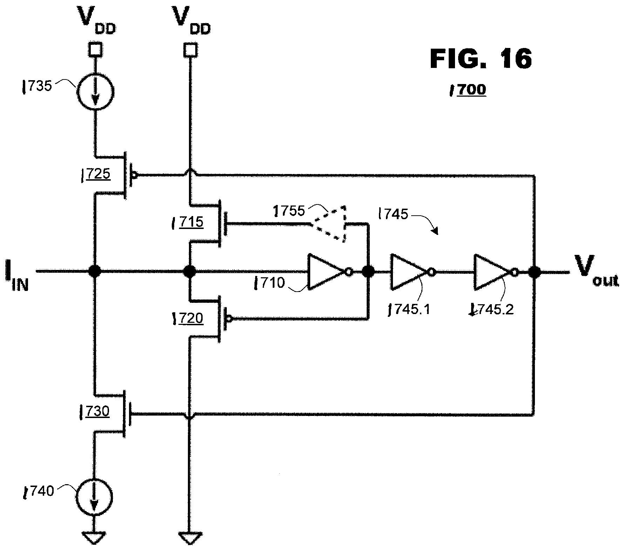

FIG. 16 illustrates an output driver 1700 according to another embodiment of the present invention. The output driver 1700 may include an inverter 1710, a pair of pulling transistors 1715, 1720, a pair of gating transistors 1725, 1730, a pair of current sources 1735, 1740 and one or more output inverters 1745. An input current signal $I_{IN}$ may be input to an input of the inverter 1710.

The pulling transistors 1715, 1720 may couple the input terminal $I_{IN}$ to respective high and low voltage supplies $V_{DD}$ and ground. Gates of the pulling transistors 1715, 1720 may be coupled to an output of the inverter 1710.

The gating transistors 1725 and 1730 and current sources 1735, 1740 may be provided in pairs. A first transistor-current source pair 1725, 1735 may provide a second circuit path between the input terminal $I_{IN}$ and the high voltage supply $V_{DD}$ in parallel to a circuit path provided by the first pulling transistor 1715. A second transistor-current source pair 1730, 1740 may provide a circuit path between the input terminal $I_{IN}$ and the low voltage supply (ground) in parallel to a circuit path that is provided by the second pulling transistor 1720. The gating transistors and pulling transistors may be provided as complementary device types. In the example illustrated in FIG. 16, the first pulling transistor 1715 is illustrated as an NMOS transistor and the first gating transistor 1725 is illustrated as a PMOS transistor. Further, the second pulling transistor 1720 is illustrated as a PMOS transistor and the second gating transistor 1730 is illustrated as an NMOS transistor. Optionally, a buffer 755 may be provided in a circuit path from the inverter output chain to a gate of transistor 1715.

Although the current sources 1735, 1740 are illustrated as ideal current sources, their operation may be gated by their associated transistors 1725 and 1730. Thus, current source 1735 will not supply current when its associated transistor 1725 is rendered non-conductive. Similarly, current source 1740 will not drive current when its associated transistor 1730 is non-conductive. Gates of the gating transistors 1725, 1730 may be coupled to a node after one of the inverters 1745. The provision of current sources 1735 and 1740 adds a hysteresis effect to operation of the output driver 1700 which reduces its sensitivity to noise and other short term transients in the input current $I_{IN}$.

The output driver 1700 may include one or more output inverters 1745. Two output inverters 1745.1, 1745.2 are illustrated in FIG. 16 although different implementations may include other numbers of inverters as may be desired. Increasing the number of inverters may increase the driver's resistance to transients in the input current signal but also may increase the latency of the driver's response to key changes in the input signal.

During operation, an input current $I_{IN}$ may be presented to the inverter 1710, in the form illustrated in FIG. 12. Responsive to the input voltage, the inverter 1710 may generate an output voltage at one of two levels, $V_{DD}$ or ground. The inverter's output may be input to the transistors 1715-1730. When the inverter's output is set to $V_{DD}$, the transistor 1715 may become conductive, which allows the input current to pass to $V_{DD}$. The transistor 1715 may be sized to weakly pull the input node to $V_{DD}$ as compared to pulls exerted by the inverter 1710. When the inverter's output is set to ground, the transistor 1720 may become conductive, which allows the input current to pass to ground. The transistor 1720 also may be sized to weakly pull the input node to ground as compared to pulls exerted by the inverter 1710.

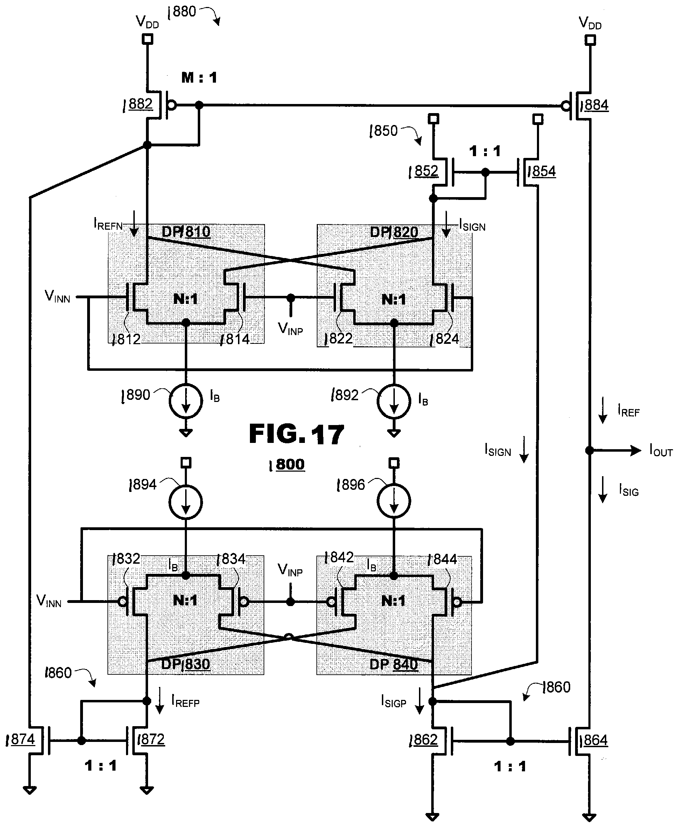

FIG. 17 illustrates a receiver circuit 1800 according to another embodiment of the present invention. There, the receiver 1800 may include four differential pair circuits 1810-1840, several current mirrors 1850-1880, and a plurality of current sources 1890-1896. The differential pair circuits 1810-840 each may include a pair of mismatched transistors, shown as having a ratio of N to 1. Two differential pair circuits 1810, 1820 may have transistors 1812, 1814, 1822 and 1824 of a first doping type (NMOS transistors, in the example illustrated in FIG. 17) and the other two differential circuits 1830, 1840 may have transistors 1832, 1834, 1842, 1844 of a complementary doping type (e.g., PMOS transistors, in this example). Tails of each of the differential pair circuits 1810-1840 may be connected to respective current sources 1890-1896.

The current mirrors 1850-1880 may be arranged to sum currents that pass through the N-sized transistors 1812, 1822, 1832 and 1842 and those that pass through the unit-sized transistors 1814, 1824, 1834, 1844. Current mirror 1850, for example, may have a first leg, provided by transistor 1852, that is coupled to the unit-sized transistors 1814, 1824 of differential pairs 1810 and 1820 and a second leg, provided by transistor 1854 for an output current $ISIG_N$. The transistor 1852 may be provided in a diode-connected configuration. Thus, an amount of current passed by the unit-sized transistors 1814, 1824 of the two differential pairs may be output to the second leg of the current mirror, also shown as $ISIG_N$.

The current mirror 1860 may have a first leg, provided by transistor 1862, that is coupled to the unit-sized transistors 1834, 1844 of differential pairs 1830 and 1840 and also to the output leg of current mirror 1850. A second leg of the current mirror 1860, provided by transistor 1864, may be coupled to the output terminal $I_{OUT}$. The transistor 1862 may be provided in a diode-connected configuration. Thus, the current mirror 1860 may generate a current signal ISIG representing a sum between $ISIG_N$ and the current passed by the unit-sized transistors 1834, 1844 of the second pair of differential pair circuits 1830, 1840.

Similarly, current mirror 1870 may have a first leg, provided by transistor 1872, that is coupled to the N-sized transistors 1832, 1842 of differential pairs 1830 and 1840 and a second leg, provided by transistor 874 for an output current $IREF_P$. The transistor 1874 may be provided in a diode-connected configuration. Thus, an amount of current passed by the N-sized transistors 1832, 1842 of the differential pairs 1830 and 1840 may be output to the second leg of the current mirror, also shown as $IREF_P$.

The current mirror 1880 may have a first leg, provided by transistor 1862, that is coupled to the N-sized transistors 1812, 1824 of differential pairs 1810 and 1820 and also to the output leg of current mirror 1870. A second leg of the current mirror 1880, provided by transistor 1884, may be coupled to the output terminal $I_{OUT}$. The transistor 1882 may be provided in a diode-connected configuration. Thus, the current mirror 1880 may generate a current signal IREF representing a sum between $IREF_P$ and the current passed by the N-sized transistors 1812, 1822 of the second pair of differential pair circuits 1810, 1820.

In an embodiment, the transistors 1882, 1884 of current mirror 1880 may be mismatched transistors with transistor 1882 being larger than transistor 1884 (shown as being M times larger). In such an embodiment, the transistor 1882 would pass M times the current that transistor 1884 passes. In other words, the current $I_{REF}$ would be to $1/M^{th}$ the current that passes through the N-sized transistors 1812, 1822, 1832 and 1842 of the differential pair circuits 1810, 1820, 1830 and 1840.

The output terminal $I_{OUT}$ of the receiver 1800 may be provided at the connection between transistors 1884 and 1864. During operation, the current mirrors 1860 and 1880 may perform a current comparison at the output terminal $I_{OUT}$. The transistor 1864 may sink an amount of current $I_{SIG}$ from the output terminal $I_{OUT}$ based on the amount of current sunk by the unit-sized transistors 1814, 1824, 1834, 1844 of the differential pair circuits 1810, 1820, 1830 and 1840. The transistor 1884 may source an amount of current $I_{REF}$ to the output terminal $I_{OUT}$ based on the amount of current sunk by the N-sized transistors 1812, 1822, 1832 and 1842 of the differential pair circuits 1810, 1820, 1830 and 1840. When $I_{REF} \neq I_{SIG}$, a residual amount of current either would be sourced output from the receiver 1800 or sunk by the receiver 1800 through the $I_{OUT}$ terminal.

During operation, the input signals $V_{INP}$ and $V_{INN}$ may toggle between two phases of operation according to the OOK signal structure of the system. In a first phase of operation, the OOK signal may be in an "OFF" state in which $V_{INP}$ and $V_{INN}$ are inactive signals. During this time, $V_{INP}$ and $V_{INN}$ each may have voltages of $\frac{1}{2}V_{DD}$ which may render all transistors of the differential pair circuits 1810, 1820, 1830 and 1840 partially conductive. The N-sized transistors 1812, 1822, 1832 and 1842 may induce a reference current through the current mirror 880 as

$$I_{REF} = \frac{4}{M} I_B.$$

$I_{REF}$ The unit-sized transistors 1814, 1824, 1834, 1844 may induce a current through the current mirror 860 as

$$I_{SIG} = \frac{4}{N} I_B.$$

When $N > M$, then $I_{REF} > I_{SIG}$ in the OFF state.

In the second phase of operation, the OOK signal may be in an "ON" state in which $V_{INP}$ and $V_{INN}$ are active signals. The $V_{INP}$ and $V_{INN}$ signals may oscillate between $V_{DD}$ and ground, centered about $\frac{1}{2}V_{DD}$. Again, $V_{INP}$ and $V_{INN}$ may not be full rail signals owing to losses within the circuit system. Conductivity of the transistors in the differential pair circuits 1810, 1820, 1830 and 1840 may vary according to these signals. The N-sized transistors 1812, 1822, 1832 and 1842 may induce a reference current as $4I_B$, which may be scaled down at the output node as

$$I_{REF} = \frac{4}{M} I_B.$$

$I_{REF}$ The unit-sized transistors 1814, 1824, 1834, 1844 may induce a current as $I_{SIG} = 2I_B$. When $M > 2$, then $I_{SIG} > I_{REF}$ in the ON state.

The parameters of N and M may be tuned to suit individual application needs. They should be set so that the current comparison at the output terminal ($I_{OUT}$) generates a first detectable state when the OOK signal is in an "OFF" state and another state when the OOK signal is in an "ON" state. Typically, M will be larger than 2.

The embodiment of FIG. 17 provides several advantages over the design shown in, for example, FIG. 11. First, by providing differential pair circuits of two process types (e.g., both PMOS and NMOS), the receiver 1800 will remain responsive to input signals at both extremes of an input voltage ($V_{DD}$ and ground). Transistors of each type may be non-responsive when a difference of voltages between their gates and their sources fail to overcome a $V_{GS}$ threshold inherent to those transistors. For NMOS transistors, the gate voltage must exceed the source voltage by the $V_{GS}$ thresholds and, when such transistors connect their sources to ground, the transistors may not be responsive to an input voltage that differs from ground by less than the transistor's $V_{GS}$ threshold. Similarly, for PMOS transistors, the gate voltage must be less than the source voltage by the $V_{GS}$ threshold and, when such transistors connect their sources to $V_{DD}$, the transistors may not be responsive to an input voltage that differs from $V_{DD}$ by less than the transistor's $V_{GS}$ threshold. In the circuit of FIG. 17, however, if the differential pairs of one doping type (say, those having the PMOS transistors) are non-responsive, the differential pairs of the complementary doping type may continue operation. Thus, the design of FIG. 17 may provide for rail-to-rail operation.

Further, the design of FIG. 17 may conserve resources as compared to the design of FIG. 11. Whereas, in the FIG. 11 embodiment, current that passes through the N-sized transistors was sourced to the supplies ($V_{DD}$ and ground), in the FIG. 17 embodiment the currents that are used in both the N-sized transistors and the unit-sized transistors are used to drive their respective current mirrors. Thus, the FIG. 17 embodiment may provide for more efficient use of resources.

The foregoing description has presented a transmitter circuit for an on-off keyed signal isolator that conserves component count and provides fast transitions between ON and OFF states. Although the foregoing embodiments have illustrated the transmitter in the context of exemplary operations and signal protocols, the principles of the present invention are not limited to the embodiments described. For example, it is permissible for a transmitter to enter an ON oscillation state when an input signal has a low voltage level, rather than a high voltage level as described hereinabove, and to enter an OFF oscillation state when the input signal has a high voltage level. Moreover, the system may be configured to operate using a single kick signal rather than complementary kick and kick_bar signals as illustrates. Further, the system may operate using an active low QUENCHING signal rather than an active high signal as illustrated in some embodiments. Such variations fall within the operating principles of the present invention. And, while MOS transistors have been illustrated herein, the principles of the present invention find application with other process technologies, for example, bipolar junction transistors and junction field effect transistors.

Several embodiments of the invention are specifically illustrated and/or described herein. However, it will be appreciated that modifications and variations of the invention are covered by the above teachings and within the purview of the appended claims without departing from the scope of the invention. Further variations are permissible that are consistent with the principles described above.

## Claims

1. A transmitter system (110) for a signal isolator system, comprising:

    an oscillator circuit (200) coupled to an isolator device (340; 440; 540; 745, 750; 860) to supply a periodic signal to the isolator device for transmission across an isolation barrier (150) of the isolator device,
    a control switch (345, 445, 545, 630, 740), coupled between the oscillator circuit and a voltage supply, the control switch having an input for an input signal to be transmitted by the system; and accelerating means (350, 450, 550, 560, 640, 650, 755, 760) for accelerating transition of the oscillator circuit on a transition between an ON state and an OFF state as determined by the input signal, wherein the accelerating means comprises a quenching switch (450, 560, 640, 755), coupled between two components of the oscillator, that becomes conductive during a transition from an ON state of the oscillator to an OFF state of the oscillator as determined by the input signal.

2. The system of claim 1, wherein the accelerating means further comprises a current injection circuit (350, 550, 650, 760), coupled to the oscillator, that becomes active during a transition from an OFF state of the oscillator to an ON state of the oscillator as determined by the input signal.

3. The transmitter system of any preceding claim, wherein the isolator device comprises a transformer (340, 440, 540), a first winding of which is an inductor (330, 430, 540) of the oscillator circuit.

4. The transmitter system of claim 1 or claim 2, wherein the oscillator circuit comprises:

    an inductor (730) connected between a pair of nodes ($N_1$, $N_2$);
    a first pair of cross-coupled transistors (710, 715), a first transistor coupled between a first one of the nodes and a first voltage supply and having a control input coupled to the second node, a second transistor coupled between the second nodes and the first voltage supply and having a control input coupled to the first node, and
    a second pair of cross-coupled transistors (720, 725), one coupled between the first node and a third node and having a control input coupled to the second node, the other transistor coupled between the second node and the third node and having a control input coupled to the first node.

5. The transmitter system of any of claims any of claims 1, 2 or 4, wherein the isolator device comprises a capacitor (745, 750).

6. The transmitter system of any of claim 1 or claim 2, wherein the oscillator circuit comprises:

    a capacitor (635) connected between a pair of nodes ($N_1$, $N_2$);
    a pair of cross-coupled transistors (610, 615), a first transistor coupled between a first one of the nodes and a first voltage supply and having a control input coupled to the second node, a second transistor coupled between the second nodes and the first voltage supply and having a control input coupled to the first node, and
    a pair of inductors (620, 625), a first inductor coupled between the first node and a second voltage supply and the second inductor coupled between the second node and the second voltage supply.

7. The transmitter system of any preceding claim, further comprising a voltage regulator (960, 1000) coupled between the voltage supply and the oscillator circuit.

8. The transmitter system of claim 6, wherein the isolator device comprises a capacitor.

9. A method of managing transitions in an ON-OFF signal isolation system, comprising:

    selectively driving an oscillator from a first supply path in response to an input signal to be transmitted across an isolation barrier of an isolator device, wherein the oscillator is driven to an ON state for one state of the input signal to supply a periodic signal to the isolator device for transmission across an isolator barrier, and is driven to an OFF state for another state of the input signal; and

when the input signal changes state to cause the oscillator to transition from an ON state to an OFF state, engaging a shortening circuit path within the oscillator, ancillary to the first supply path, to alter an amount of current passing through the oscillator.

10. The method of claim 9, further comprising, when the input signal changes state to cause the oscillator to transition from an OFF state to the ON state, engaging a further circuit path, ancillary to the first supply path, to inject current into the oscillator from the further circuit path.

11. The method of any of claim 9 or claim 10, where at least one of the following apply:

    a) the shorting current path remains active for an entire duration of the OFF state;
    b) the shorting current path remains active only for an initial portion of the OFF state.

12. The method of any of claim 10 or claim 11, further comprising terminating the current injection after a predetermined portion of the ON state has elapsed.

13. A multi-channel transmitter system for a signal isolator system, comprising:
a plurality of channels for transmission of respective signals across an isolation barrier, each channel comprising a transmitter system as claimed in any of claims 1 to 8, and an isolator device.

14. The system of claim 13, wherein the transmitters each transmit their respective signals in a common direction across the isolation barrier.

15. The system of claim 13, wherein at least one transmitter transmits its respective signal in a first direction across the isolation barrier and at least one other transmitter transmits its respective signal in a second direction across the isolation barrier, opposite the first direction.

**Patentansprüche**

1. Übertragungssystem (110) für ein Signalisolatorsystem, das Folgendes umfasst:

eine Oszillatorschaltung (200), die mit einer Isolatorvorrichtung (340; 440; 540; 745, 750; 860) gekoppelt ist, um ein periodisches Signal an die Isolatorvorrichtung zur Übertragung über eine Isolationsbarriere (150) der Isolatorvorrichtung zuzuführen, einen Steuerschalter (345, 445, 545, 630, 740), der zwischen die Oszillatorschaltung und eine Spannungszuführung gekoppelt ist, wobei der Steuerschalter einen Eingang für ein Eingangssignal aufweist, das von dem System übertragen werden soll; und Beschleunigungsmittel (350, 450, 550, 560, 640, 650, 755, 760) zum Beschleunigen des Übergangs der Oszillatorschaltung bei einem Übergang zwischen einem EIN-Zustand und einem AUS-Zustand, wie durch das Eingangssignal bestimmt, wobei das Beschleunigungsmittel einen Löschschalter (450, 560, 640, 755) umfasst, der zwischen zwei Komponenten des Oszillators gekoppelt ist und der während eines Übergangs von einem EIN-Zustand des Oszillators zu einem AUS-Zustand des Oszillators, wie durch das Eingangssignal bestimmt, leitfähig wird.

2. System nach Anspruch 1, wobei das Beschleunigungsmittel ferner eine mit dem Oszillator gekoppelte Strominjektionsschaltung (350, 550, 650, 760) umfasst, die während eines Übergangs von einem AUS-Zustand des Oszillators zu einem EIN-Zustand des Oszillators, wie durch das Eingangssignal bestimmt, aktiv wird.

3. Übertragungssystem nach einem der vorangehenden Ansprüche, wobei die Isolatorvorrichtung einen Transformator (340, 440, 540) umfasst, wobei eine erste Wicklung dieses Transformators einen Induktor (330, 430, 540) der Oszillatorschaltung darstellt.

4. Übertragungssystem nach Anspruch 1 oder Anspruch 2, wobei die Oszillatorschaltung Folgendes umfasst:

einen Induktor (730), der zwischen einem Paar Knoten ($N_1$, $N_2$) verbunden ist; ein erstes Paar kreuzgekoppelter Transistoren (710, 715), wobei ein erster Transistor zwischen einem ersten der Knoten und einer ersten Spannungszuführung gekoppelt ist und einen mit dem zweiten Knoten gekoppelten Steuereingang aufweist, wobei ein zweiter Transistor zwischen den zweiten Knoten und der ersten Spannungszuführung gekoppelt ist und einen mit dem ersten Knoten gekoppelten Steuereingang aufweist, und ein zweites Paar kreuzgekoppelter Transistoren (720, 725), wobei einer zwischen dem ersten Knoten und einem dritten Knoten gekoppelt ist und einen mit dem zweiten Knoten gekoppelten Steuereingang aufweist, wobei der andere Transistor zwischen dem zweiten Knoten und dem dritten Knoten gekoppelt ist und einen mit dem ersten Knoten gekoppelten Steuereingang aufweist.

5. Übertragungssystem nach einem der Ansprüche 1, 2 oder 4, wobei die Isolatorvorrichtung einen Kondensator (745, 750) umfasst.

6. Übertragungssystem nach Anspruch 1 oder Anspruch 2, wobei die Oszillatorschaltung Folgendes umfasst:

> einen Kondensator (635), der zwischen einem Paar Knoten ($N_1$, $N_2$) verbunden ist;
> ein Paar kreuzgekoppelter Transistoren (610, 615), wobei ein erster Transistor zwischen einen ersten der Knoten und einer ersten Spannungszuführung gekoppelt ist und einen mit dem zweiten Knoten gekoppelten Steuereingang aufweist, wobei ein zweiter Transistor zwischen die zweiten Knoten und der ersten Spannungszuführung gekoppelt ist und einen mit dem ersten Knoten gekoppelten Steuereingang aufweist, und ein Paar Induktoren (620, 625), wobei ein erster Induktor zwischen den ersten Knoten und einer zweiten Spannungszuführung gekoppelt ist und der zweite Induktor zwischen den zweiten Knoten und der zweiten Spannungszuführung gekoppelt ist.

7. Übertragungssystem nach einem der vorangehenden Ansprüche, das ferner einen Spannungsregler (960, 1000) umfasst, der zwischen der Spannungszuführung und der Oszillatorschaltung gekoppelt ist.

8. Übertragungssystem nach Anspruch 6, wobei die Isolatorvorrichtung einen Kondensator umfasst.

9. Verfahren zum Verwalten von Übergängen in einem EIN-AUS-Signalisolatorsystem, das Folgendes umfasst:

> selektives Ansteuern eines Oszillators von einem ersten Zuführungspfad als Reaktion auf ein Eingangssignal, das über eine Isolationsbarriere einer Isolatorvorrichtung zu übertragen ist, wobei der Oszillator für einen Zustand des Eingangssignals in einen EIN-Zustand angesteuert wird, um ein periodisches Signal an die Isolatorvorrichtung zur Übertragung über eine Isolatorbarriere zuzuführen, und für einen anderen Zustand des Eingangssignals in einen AUS-Zustand angesteuert wird; und
> wenn das Eingangssignal seinen Zustand verändert, um den Oszillator von einem EIN-Zustand in einen AUS-Zustand zu versetzen, Aktivieren eines Kurzschaltungspfads innerhalb des Oszillators, der dem ersten Zuführungspfad untergeordnet ist, um eine durch den Oszillator fließende Strommenge zu ändern.

10. Verfahren nach Anspruch 9, das ferner, wenn das Eingangssignal seinen Zustand verändert, um den Oszillator von einem AUS-Zustand in den EIN-Zustand zu versetzen, das Einschalten eines weiteren, dem ersten Zuführungspfad untergeordneten Schaltungspfads umfasst, um Strom aus dem weiteren Schaltungspfad in den Oszillator einzuspeisen.

11. Verfahren nach einem der Ansprüche 9 oder 10, wobei mindestens einer der folgenden Punkte zutrifft:

> a) der Kurzschlussstrompfad bleibt für die gesamte Dauer des AUS-Zustandes aktiv;
> b) der Kurzschlussstrompfad bleibt nur für einen Anfangsabschnitt des AUS-Zustandes aktiv.

12. Verfahren nach einem der Ansprüche 10 oder 11, das ferner das Beenden der Strominjektion nach Ablauf eines vorbestimmten Abschnitts des EIN-Zustands umfasst.

13. Mehrkanaliges Übertragungssystem für ein Signalisolatorsystem, das Folgendes umfasst:
mehrere Kanäle zur Übertragung der jeweiligen Signale über eine Isolationsbarriere, wobei jeder Kanal ein Übertragungssystem nach einem der Ansprüche 1 bis 8 und eine Isolatorvorrichtung umfasst.

14. System nach Anspruch 13, wobei die Transmitter ihre jeweiligen Signale in eine gemeinsame Richtung über die Isolationsbarriere hinweg übertragen.

15. System nach Anspruch 13, wobei mindestens ein Transmitter sein jeweiliges Signal in einer ersten Richtung über die Isolationsbarriere überträgt und mindestens ein anderer Transmitter sein jeweiliges Signal in einer zweiten Richtung über die Isolationsbarriere entgegengesetzt zur ersten Richtung überträgt.

**Revendications**

1. Système émetteur (110) pour un système isolateur de signal, comprenant :

> un circuit oscillateur (200) couplé à un dispositif isolateur (340 ; 440 ; 540 ; 745, 750 ; 860) pour délivrer un signal périodique au dispositif isolateur pour la transmission à travers une barrière d'isolation (150) du dispositif isolateur,
> un commutateur de commande (345, 445, 545, 630, 740), couplé entre le circuit oscillateur et une alimentation en tension, le commutateur de commande ayant une entrée pour un signal d'entrée devant être transmis par le système ; et un moyen d'accélération (350, 450, 550, 560, 640, 650, 755, 760) pour accélérer la transition du circuit oscillateur lors d'une transition entre un état MARCHE et un état ARRÊT tel que déterminé par le signal d'entrée, dans lequel le moyen d'accélération comprend un commutateur de coupure (450, 560, 640, 755), couplé entre deux composants de l'oscillateur, qui devient conducteur durant une transition d'un état MARCHE de l'oscillateur à un état ARRÊT de l'oscillateur tel que déterminé par le signal d'entrée.

2. Système selon la revendication 1, dans lequel le moyen d'accélération comprend en outre un circuit d'injection de courant (350, 550, 650, 760), couplé à l'oscillateur, qui devient actif durant une transition d'un état ARRÊT de l'oscillateur à un état MARCHE de l'oscillateur tel que déterminé par le signal d'entrée.

3. Système émetteur selon l'une quelconque des revendications précédentes, dans lequel le dispositif isolateur comprend un transformateur (340, 440, 540), dont un premier enroulement est une bobine d'induction (330, 430, 540) du circuit oscillateur.

4. Système émetteur selon la revendication 1 ou la revendication 2, dans lequel le circuit oscillateur comprend :

   une bobine d'induction (730) connectée entre une paire de nœuds (N$_1$, N$_2$) ;
   une première paire de transistors à couplage transversal (710, 715), un premier transistor couplé entre un premier des nœuds et une première alimentation en tension et ayant une entrée de commande couplée au deuxième nœud, un deuxième transistor couplé entre les deuxièmes nœuds et la première alimentation en tension et ayant une entrée de commande couplée au premier nœud, et
   une deuxième paire de transistors à couplage transversal (720, 725), l'un couplé entre le premier nœud et un troisième nœud et ayant une entrée de commande couplée au deuxième nœud, l'autre transistor couplé entre le deuxième nœud et le troisième nœud et ayant une entrée de commande couplée au premier nœud.

5. Système émetteur selon l'une quelconque des revendications 1, 2 ou 4, dans lequel le dispositif isolateur comprend un condensateur (745, 750).

6. Système d'émetteur selon l'une quelconque de la revendication 1 ou de la revendication 2, dans lequel le circuit oscillateur comprend :

   un condensateur (635) connecté entre une paire de nœuds (N$_1$, N$_2$) ;
   une paire de transistors à couplage transversal (610, 615), un premier transistor couplé entre un premier des nœuds et une première alimentation en tension et ayant une entrée de commande couplée au deuxième nœud, un deuxième transistor couplé entre les deuxièmes nœuds et la première alimentation en tension et ayant une entrée de commande couplée au premier nœud, et
   une paire de bobines d'induction (620, 625), une première bobine d'induction couplée entre le premier nœud et une deuxième alimentation en tension et la deuxième bobine d'induction couplée entre le deuxième nœud et la deuxième alimentation en tension.

7. Système émetteur selon une quelconque revendication précédente, comprenant en outre un régulateur de tension (960, 1000) couplé entre l'alimentation en tension et le circuit oscillateur.

8. Système d'émetteur selon la revendication 6, dans lequel le dispositif isolateur comprend un condensateur.

9. Procédé de gestion des transitions dans un système d'isolation de signaux MARCHE-ARRÊT, comprenant :

   le pilotage sélectif d'un oscillateur à partir d'une première voie d'alimentation en réponse à un signal d'entrée devant être transmis à travers une barrière d'isolation d'un dispositif isolateur, dans lequel l'oscillateur est piloté vers un état MARCHE pour un état du signal d'entrée pour délivrer un signal périodique au dispositif isolateur pour la transmission à travers une barrière d'isolation, et est piloté vers un état ARRÊT pour un autre état du signal d'entrée ; et
   lorsque le signal d'entrée change d'état pour provoquer la transition de l'oscillateur d'un état MARCHE à un état ARRÊT, l'utilisation d'une voie de circuit raccourcie à l'intérieur de l'oscillateur, accessoire à la première voie d'alimentation, pour modifier la quantité de courant passant à travers l'oscillateur.

10. Procédé selon la revendication 9, comprenant en outre, lorsque le signal d'entrée change d'état pour provoquer la transition de l'oscillateur d'un état ARRÊT à un état MARCHE, l'utilisation d'une voie de circuit supplémentaire, accessoire à la première voie d'alimentation, pour injecter du courant dans l'oscillateur à partir de la voie de circuit supplémentaire.

11. Procédé selon l'une quelconque de la revendication 9 ou de la revendication 10, dans lequel au moins l'un des cas suivants s'applique :

   a) la voie de courant de court-circuit reste active pendant la durée entière de l'état ARRÊT ;
   b) la voie de courant de court-circuit reste active seulement pendant la partie initiale de l'état ARRÊT.

12. Procédé selon l'une quelconque de la revendication 10 ou de la revendication 11, comprenant en outre l'interruption de l'injection de courant après qu'une partie prédéterminée de l'état MARCHE s'est écoulée.

13. Système émetteur multicanal pour un système isolateur de signal, comprenant :
   une pluralité de canaux pour la transmission des signaux respectifs à travers une barrière d'isolation, chaque canal comprenant un système émetteur selon l'une quelconque des revendications 1 à 8, et un dispositif isolateur.

14. Système selon la revendication 13, dans lequel les émetteurs transmettent chacun leurs signaux respectifs dans une direction commune à travers la barrière d'isolation.

15. Système selon la revendication 13, dans lequel au moins un émetteur transmet son signal respectif dans une première direction à travers la barrière d'isolation et au moins un autre émetteur transmet son signal respectif dans une deuxième direction à travers la barrière d'isolation, opposée à la première direction.

**FIG. 1**
**100**

**(b)**

Input

Output

ON    OFF    ON

**FIG. 2**

TRANSMITTER **200**  **(a)**

**FIG. 3**

**300**

(a)

(b)

EP 2 996 246 B1

# FIG. 4

## 400

(a)

(b)

EP 2 996 246 B1

**FIG. 5**
**500**

KICKSTART CIRCUIT 550

1:n

Vdd

551  552  553

kick

555

CTR'L 570

Input

kick
kick_bar
quenching
switch

510  515

N1

560

quenching

N2

520  525

545

kick_bar  554

Vdd

565

Output

540

535  530

**(a)**

Input
kick
kick_bar
quench
switch
Output

ON    OFF    ON

**(b)**

EP 2 996 246 B1

# FIG. 7

**700**

# FIG. 6

**600**

# FIG. 8

## 800

# FIG. 9

## 900

# FIG. 10

1000

**FIG. 11**

(200

**FIG. 12**

(300

EP 2 996 246 B1

**FIG. 13**

|400

**FIG. 15**

|600

**FIG. 14**

|500

EP 2 996 246 B1

FIG. 16

*700*

EP 2 996 246 B1

FIG. 17

800

**REFERENCES CITED IN THE DESCRIPTION**

**Patent documents cited in the description**

- WO 2012085951 A1

- US 20090195082 A1